# EUROPÄISCHE PATENTSCHRIFT

(11) **EP 2 757 381 B1**
(45) Veröffentlichungstag und Bekanntmachung des Hinweises auf die Patenterteilung: **11.01.2023**
(21) Anmeldenummer: 14151770.6
(22) Anmeldetag: 20.01.2014
(51) Int. Cl.: G01R 7/02, H02H 3/32, H02H 3/33

(54) **E/A Gerät mit einer Stromflussüberwachungseinheit und Verwendung eines solchen**
I/O device with a current flow monitoring device and use of same
Appareil E/S doté d'une unité de surveillance du flux de courant et utilisation de celui-ci

(30) Priorität: 21.01.2013 DE 102013000846
(43) Veröffentlichungstag der Anmeldung: 23.07.2014
(73) Patentinhaber: Phoenix Contact GmbH & Co. KG, 32825 Blomberg (DE)
(72) Erfinder: Oster, Viktor, 32825 Blomberg (DE); Säck, Klaus-Peter, 32760 Detmold (DE)
(74) Vertreter: Blumbach · Zinngrebe Patentanwälte PartG mbB

(56) Entgegenhaltungen:
- EP-A2- 2 393 178
- WO-A1-2011/085958
- US-A- 5 539 602

## Beschreibung

Die Erfindung betrifft die Verwendung eines E/A Automatisierungsgerätes der funktionalen Sicherheit in einem sicherheitskritischen Prozess mit einer Stromflussüberwachungseinheit zum Diagnostizieren einer fehlerhaften Installation von an dem E/A-Automatisierungsgerät angeschlossenen sicheren Aktoren/Sensoren.

Bekanntermaßen werden in der Regel sowohl Aktoren wie auch Sensoren, welche im Feld installiert sind, bei der klassischen Installation über eine Rangierebene angeschlossen. Über diese Rangierebene erfolgt die Verdrahtung an die Aus- bzw. Eingänge von Eingangs-/Ausgangs-Automatisierungsgeräten, nachfolgend als E/A-Automatisierungsgeräte bezeichnet, welche somit die Anbindung zu diesen Aktoren wie auch Sensoren bereitstellen, in sogenannter Einleiteranschlusstechnik. So empfangen die E/A-Automatisierungsgeräte von angebundenen Sensoren, Eingangssignale zur weiteren Verarbeitung und/oder geben an angebundene Aktoren anwendungsspezifisch verarbeitete Ausgangssignale aus.

Der gemeinsame Bezugspunkt der Installation wird hierbei in der Regel auf einer Sammelschiene aufgelegt, wobei zwischen der Sammelschiene und den E/A-Automatisierungsgeräten, dann oftmals nur eine einzige Verbindung vorhanden ist. Bei solchen Installationen kann es jedoch durch Unterbrechung einer einzigen Leitung zu Spannungsverschleppungen kommen, die ein kontrolliertes Schalten von Ein- und/oder Ausgängen der E/A-Automatisierungsgeräte unmöglich machen. Solche Verhalten sind bekannt und führten bei der Entwicklung von integrierten Ausgangstreibern zu einer Schaltungsauslegung, welche unter anderem als "Protection against loss of ground" beschrieben wird.

Die vorstehend beschriebene Installationstechnik wird darüber hinaus oftmals auf die Installation sicherer Aktoren und Sensoren übertragen, wobei eine Unterbrechung in der Sammelschiene dann ggf. zu unvorhersehbaren Effekten führen kann.

Sichere Einheiten, wie z.B. auch sichere Aktoren und Sensoren, werden heute insbesondere innerhalb eines sicherheitsrelevanten oder sicherheitskritischen Prozess eingesetzt.

Unter einem sicherheitsrelevanten oder sicherheitskritischen Prozess wird im Rahmen der Erfindung ein Prozess verstanden, von dem bei Auftreten eines Fehlers eine nicht zu vernachlässigende Gefahr für Menschen und/oder auch materielle Güter ausgehen kann. Bei einem sicherheitsrelevanten oder sicherheitskritischen Prozess muss daher mit im Idealfall 100-prozentiger Sicherheit gewährleistet sein, dass bei Vorliegen eines Fehlers dieser Prozess, ein mit diesem Prozess gekoppelter Folgeprozess und/oder ein diesen Prozess umfassendes Gesamtsystem in einen sicheren Zustand überführt wird, von dem also keinerlei Gefahr mehr ausgehen kann. Derartige sicherheitsrelevante oder sicherheitskritische Prozesse können somit auch Teilprozesse von größeren, übergeordneten Gesamtprozessen sein. Beispiele für sicherheitsrelevante oder sicherheitskritische Prozesse sind chemische Verfahren, bei denen kritische Parameter unbedingt in einem vorgegebenen Bereich gehalten werden müssen, komplexe Maschinensteuerungen, wie etwa bei einer hydraulischen Presse oder einer Fertigungsstraße, bei welchen beispielsweise das Inbetriebnehmen eines Press-/Schneidwerkzeuges einen sicherheitsrelevanten Teilprozess darstellen kann. Weitere Beispiele für sicherheitsrelevante oder sicherheitskritische (Teil-) Prozesse sind die Überwachung von Schutzgittern, Schutztüren oder Lichtschranken, die Steuerung von Zweihandschaltern oder auch die Reaktion auf Notausschalter. Für alle sicherheitsrelevanten Prozesse ist es somit unbedingt erforderlich, dass die jeweils zugehörigen, für die Sicherheit relevanten Signale und Daten ohne irgendeine Verfälschung zeitnah transportiert werden, da jede Verfälschung eine fehlerhafte Funktion und/oder Reaktion zur Folge haben kann, die in letzter Konsequenz das Leben und die Gesundheit von Personen gefährden kann.

Um den Sicherheitsanforderungen gerecht zu werden, hat es in den letzten Jahren zahlreiche Vereinbarungen gegeben, die einen nahezu fehlerfreien Datentransport fordern. Diese betreffen insbesondere den Signal-/Datentransport selbst sowie eine zulässige Restfehlerwahrscheinlichkeit in Abhängigkeit der jeweiligen Anwendung bzw. des jeweiligen Prozesses. Für die Einheiten, die für einen nahezu fehlerfreien Signal-/Datentransport Sorge tragen und/oder mit nahezu 100-prozentiger Sicherheit gewährleisten sollen, dass bei Vorliegen eines Fehlers ein sicherer Zustand eingenommen wird, wurden daher unterschiedliche interne Sicherheitsstrukturen entwickelt, so dass Bauteilausfälle, Systemunterbrechungen, das Ausbleiben oder Verfälschen von Signalen oder Daten beim Signal-/Datentransport erkannt werden. Derartige, interne Sicherheitsstrukturen besitzende Einheiten werden nachfolgend als sicher bezeichnet. Derartige sichere Einheiten können sich teilweise auch gegenseitig überprüfen, so dass auch die fehlerhafte Aktivität einer anderen Einheit festgestellt werden kann.

Signale und Daten werden nachfolgend als sicher bezeichnet, die für die Sicherheit relevante Signale oder Daten umfassen und deren Transport und/oder hierfür notwendige Verarbeitung auch unter Einbeziehung von sicheren Einheiten erfolgt. Folglich erfolgt deren Auswertung je nach angewandter Sicherheitsstruktur entsprechend sicherheitsgerichtet.

Um daher das Risiko, dass eine Unterbrechung in einer Sammelschiene zu unvorhersehbaren Effekten führen kann, ausschließen zu können, wird daher bei sicheren Aktoren und Sensoren grundsätzlich der Zweileiteranschluss vorgeschrieben. Diese rein organisatorische Maßnahme hat jedoch den Nachteil, dass ein fehlerhafter Anschluss nicht diagnostiziert werden kann. Eine fehlerhafte Installation einschließlich eines fehlerhaften Anschlusses beeinträchtigt jedoch die funktionale Sicherheit, von welcher maßgeblich auch die Restfehlerwahrscheinlichkeit abhängig ist.

Bekanntermaßen gehört zur funktionalen Sicherheit jedoch nicht die elektrische Sicherheit, in Bezug auf welche z.B. aus der DE 10 2006 025 604 A1 Stromflussmessungen für die Durchführung von Differenzstrommessungen bekannt sind, um einen auftretenden Isolationsfehler frühzeitig zu erkennen, bevor ein Kurzschluss zu einem größeren Schaden führt.

Die europäische Patentanmeldung EP 2 393 178 A2 beschreibt eine Schutzvorrichtung für eine elektrische Gleichstromerzeugungsvorrichtung wie ein Array-System aus Photovoltaikmodulen, umfassend einen ersten, zweiten, dritten und vierten Anschluss, mindestens einen Stromsensor zur Erfassung eines zwischen den ersten und zweiten Anschlüssen oder zwischen den dritten und vierten Anschlüssen fließenden Stroms, einen Spannungssensor zum Erfassen einer Spannung zwischen dem ersten und dem dritten Anschluss, mindestens einen Schalter zum Unterbrechen des zwischen den ersten und zweiten Anschlüssen oder zwischen den dritten und vierten Anschlüssen fließenden Stroms, und einen mit dem mindestens einen Stromsensor, dem Spannungssensor und dem mindestens einen Schalter zusammenarbeitenden Prozessor zum Bereitstellen eines Vorwärtsfehlerschutzes für die elektrische Gleichstromerzeugungsvorrichtung. Jedem einzelnen Photovoltaikmodul der Gleichstromerzeugungsvorrichtung wird ein eigenes Überwachungsmodul als Schutzvorrichtung bereitgestellt.

Die WO 2011/085958 A1 betrifft eine Vorrichtung zur elektrischen Stromkreisüberwachung eines wenigstens einen elektrischen Verbraucher umfassenden Verbraucherstromkreises, wobei zwei Versorgungsspannungsanschlüsse über je einen ersten Halbleiterschalter aufweisende Strompfade mit den beiden Verbraucheranschlüssen verbunden sind. Die Stromerfassungsmittel dienen zur Erfassung des Stroms in jedem der beiden Strompfade. Zu je einem Hochstromshunt in jedem der beiden Strompfade ist die Reihenschaltung eines weiteren Halbleiterschalters mit einem Niederstromshunt parallel geschaltet, wobei die beiden Anschlüsse der Niederstromshunts jeweils mit den Stromerfassungsmitteln verbunden sind.

Die US 5 539 602 A offenbart einen in einem Messzustand betreibbaren Erdschlussunterbrecher, der mit einem eine Gleichstromquelle und eine Last aufweisenden Gleichstromkreis verwendet wird. Die Gleichstromquelle liefert Gleichstrom an die Last entlang eines Versorgungsstrompfads und empfängt Gleichstrom von der Last entlang eines Rückstrompfads. Der Erdschlussunterbrecher umfasst einen ersten Widerstand in Reihe mit dem Versorgungsstrompfad, einen zweiten Widerstand in Reihe mit dem Rückstrompfad und einen in Reihe mit einem der Strompfade angeordneten Stromunterbrecher. Infolge einer Aktivierung unterbricht der Stromunterbrecher den einen der Strompfade. Der Erdschlussunterbrecher umfasst ferner eine Messeinheit zum Messen von Spannungsabfällen über dem jeweiligen ersten und zweiten Widerstand während des Messzustands, zum Erhalten eines Messwerts unter Verwendung einer Differenz zwischen den Spannungsabfällen und zum Vergleichen des Messwerts mit einem vorbestimmten Schwellenwert. Die Messeinheit ist dazu ausgebildet und angeordnet, den Stromunterbrecher in Reaktion darauf, dass der Messwert den vorbestimmten Schwellenwert überschreitet, zu aktivieren.

Aufgabe der Erfindung ist es, einen Weg bereitzustellen, mit welchem eine fehlerhafte Installation bei einem E/A-Automatisierungsgerät mit daran über Zweileiteranschlüsse angeschlossenen Aktoren und/oder Sensoren detektiert und also die funktionale Sicherheit erhöht werden kann, insbesondere auch, wenn bei der Installation die Versorgungsspannungsanschlüsse, z.B. über Sammelschienen, an eine gemeinsame Spannungsversorgung geführt sind.

Die Lösung der vorstehend genannten Aufgabe ist durch einen Gegenstand mit den Merkmalen des unabhängigen Anspruchs 1 gegeben.

Demgemäß sieht die Erfindung die Verwendung eines E/A-Automatisierungsgerätes der funktionalen Sicherheit in einem sicherheitskritischen Prozess zum Diagnostizieren einer fehlerhaften Installation von an dem E/A-Automatisierungsgerät angeschlossenen sicheren Aktoren und/oder sicheren Sensoren vor, wobei das E/A-Automatisierungsgerät von den angebundenen Sensoren Eingangssignale zur weiteren Verarbeitung empfangen und/oder an die angebundenen Aktoren anwendungsspezifisch verarbeitete Ausgangssignale ausgeben kann. Das E/A-Automatisierungsgerät wird zur Überwachung der funktionalen Sicherheit verwendet und ist ausgestattet mit wenigstens einem zweipoligen Spannungsversorgungsanschluss zum Anschließen an eine Spannungsversorgung und mit wenigstens zwei zweipoligen Peripherieanschlüssen, welche als zweipolige Eingangsperipherieanschlüsse zum Anschließen einer entsprechenden Anzahl von sicheren Sensoren über Zweileiteranschlüsse oder als zweipolige Ausgangsperipherieanschlüsse zum Anschließen einer entsprechenden Anzahl von sicheren Aktoren ausgebildet sind, wobei von einem ersten Pol des Spannungsversorgungsanschlusses ausgehend ein erster Strompfad im E/A-Automatisierungsgerät beherbergt ist, der für einen Stromfluss in Richtung zu einem jeweils ersten Pol der wenigstens zwei zweipoligen Peripherieanschlüsse dient, und von dem zweiten Pol des Spannungsversorgungsanschlusses ausgehend ein zweiter Strompfad im E/A-Automatisierungsgerät beherbergt ist, der für einen Stromfluss aus Richtung der wenigstens zwei zweipoligen Peripherieanschlüsse dient. Die an die wenigstens zwei zweipoligen Peripherieanschlüsse anzuschließenden sicheren Aktoren oder sicheren Sensoren werden dabei parallel zueinander zwischen dem ersten und dem zweiten Strompfad installiert. Das E/A-Automatisierungsgerät wird ferner mit einer Stromflussüberwachungseinheit zum Diagnostizieren einer fehlerhaften Installation zwischen der Spannungsversorgung und wenigstens einem an einem der wenigstens zwei zweipoligen Peripherieanschlüsse angeschlossenen Aktor oder Sensor und also zur Überwachung der funktionalen Sicherheit, verwendet, derart, dass nach Installation des Spannungsversorgungsanschlusses an die Spannungsversorgung und eines Aktors oder Sensors an jeden der wenigstens zwei Peripherieanschlüsse von der Stromflussüberwachungseinheit in Bezug auf den jeweils ersten Pol der wenigstens zwei zweipoligen Peripherieanschlüsse wenigstens ein erster, über den ersten Strompfad geleiteter Stromfluss sowie in Bezug auf den jeweils zweiten Pol des wenigstens einen zweipoligen Peripherieanschlusses wenigstens ein zweiter, über den zweiten Strompfad geleiteter Stromfluss gemessen wird, wobei entweder ein Stromfluss als erster Stromfluss gemessen wird, der insgesamt in Richtung der jeweils ersten Pole der wenigstens zwei zweipoligen Peripherieanschlüsse geführt wird, sowie ein Stromfluss als zweiter Stromfluss gemessen wird, der insgesamt aus Richtung der wenigstens zwei zweipoligen Peripherieanschlüsse abgeführt wird, und hieraus ein gemeinsamer Installationsüberwachungswert gebildet wird, oder für jeden ersten Pol der wenigstens zwei zweipoligen Peripherieanschlüsse jeweils ein eindeutig zuordenbarer Stromfluss als erster Stromfluss gemessen wird, sowie für jeden der wenigstens zwei zweipoligen Peripherieanschlüsse ein aus dieser Richtung kommender, eindeutig zuordenbarer Stromfluss als zweiter Stromfluss gemessen wird und hieraus für jeden Peripherieanschluss jeweils ein eindeutig zuordenbarer Installationsüberwachungswert gebildet wird, ferner die gemessenen Stromflüsse zur Bildung wenigstens eines Installationsüberwachungswertes miteinander verglichen werden, jeder gebildete Installationsüberwachungswert gegenüber wenigstes einem vorgebbaren oder vorgegebenen Grenzwert verglichen wird, und bei Erreichen oder Über-/Unterschreiten eines Grenzwertes durch wenigstens einen der Installationsüberwachungswerte auf einen Installationsfehler erkannt und zur Anzeige des Vorliegens eines Installationsfehlers ein Installationsfehlersignal erzeugt und ausgegeben wird.

Bevorzugte Ausführungsformen und/oder Weiterbildungen sind Gegenstand der abhängigen Ansprüche.

Die Erfindung bietet somit insgesamt den Vorteil, dass durch Messung und Auswertung des Stromflusses sowohl in der Plusleitung als auch in der Minusleitung gemessen eine fehlerhafte Installation detektiert und also die funktionale Sicherheit erhöht werden kann. Überschreitet die Differenz der beiden Messwerte einen vorher definierten Wert, ist die Stromflussüberwachungseinheit konzipiert, davon auszugehen, dass der Anschluss eines Aktors oder eines Sensors nicht den Vorgaben einer korrekten Installation entspricht und hierauf basierend ein Installationsfehlersignal als Diagnosemeldung zu erzeugen, die auf einen Installationsfehler hinweist, bevor überhaupt eine unkontrollierbare Situation entstehen kann.

Die Diagnose kann darüber hinaus entweder lokal auf dem E/A-Automatisierungsgerät selbst, z.B. mittels einer Diagnoseanzeige erfolgen oder in weiterer bevorzugter Ausführungsform über einen Meldeausgang in den Prozess zurückgemeldet werden. Ergänzend oder alternativ sieht die Erfindung ferner vor, die Diagnose über ein Bussystem an eine überlagerte Steuerung zu melden und/oder die Diagnose direkt auf die Ein- bzw. Ausgänge, d.h. auf die Peripherieanschlüsse des E/A-Automatisierungsgerätes wirken zu lassen.

Die Erfindung wird nachfolgend anhand bevorzugter Ausführungsformen unter Bezugnahme auf die beigefügten Zeichnungen näher beschrieben. In den Zeichnungen zeigen:

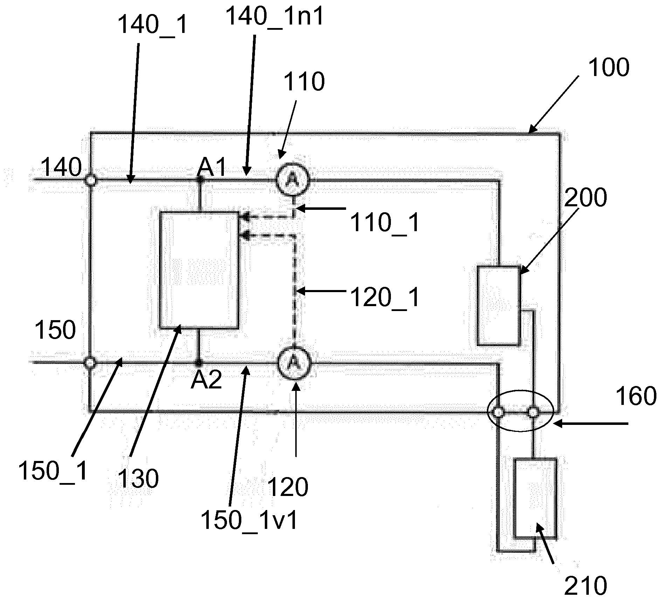

- Fig. 1: ein stark vereinfachtes, das Prinzip eines E/A-Automatisierungsgerätes mit einem zweipoligen Peripherieanschluss veranschaulichendes Schaltbild mit einer integrierten Stromflussüberwachungseinheit, die verwendet wird, eine fehlerhafte Installation im Falle von einem angeschlossen Aktor zu detektieren,

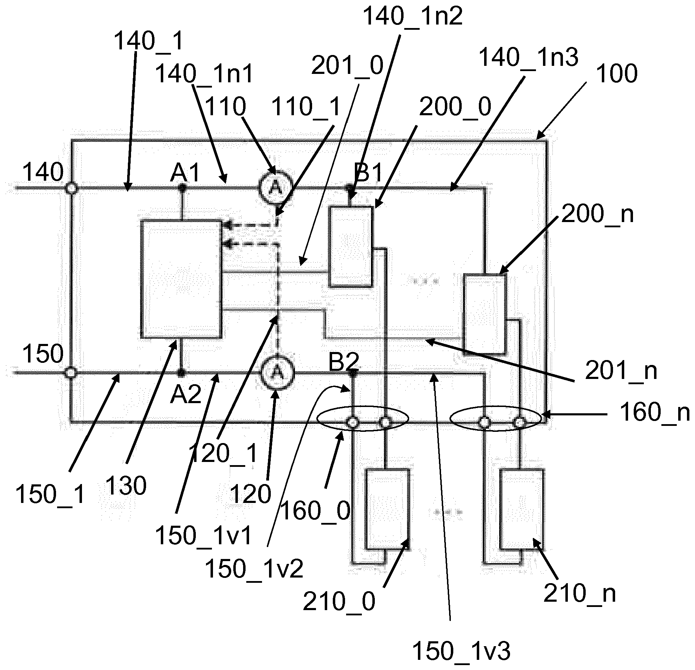

- Fig. 2: ein stark vereinfachtes, das Prinzip eines im Rahmen der Erfindung verwendbaren E/A-Automatisierungsgerätes veranschaulichendes Schaltbild mit einer integrierten Stromflussüberwachungseinheit, die verwendet wird, eine fehlerhafte Installation im Falle von zwei angeschlossen Aktoren zu detektieren, und

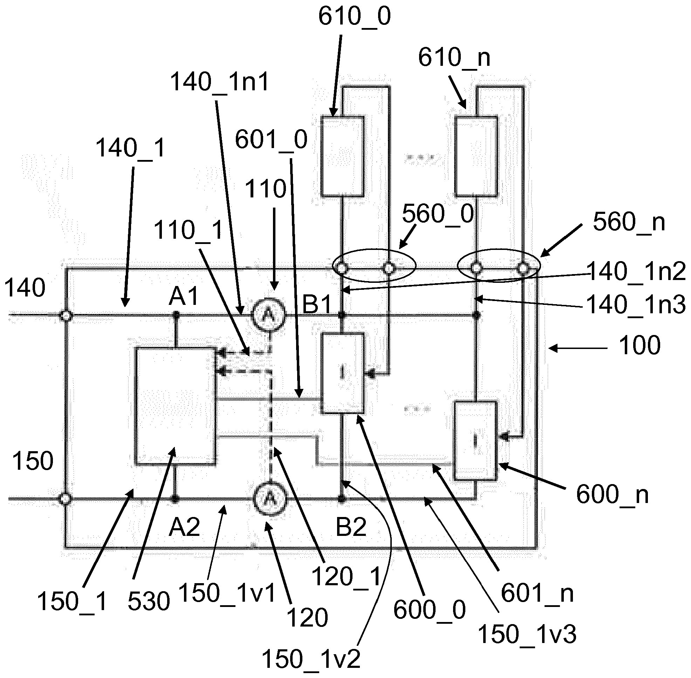

- Fig. 3: ein stark vereinfachtes, das Prinzip eines weiteren im Rahmen der Erfindung verwendbaren E/A-Automatisierungsgerätes veranschaulichendes Schaltbild mit einer integrierten Stromflussüberwachungseinheit, die verwendet wird, eine fehlerhafte Installation im Falle von zwei angeschlossen Sensoren zu detektieren.

Nachfolgend wird die Erfindung detaillierter beschrieben, wobei die Figuren 2 und 3 zwei Ausführungsbeispiele eines im Rahmen der Erfindung verwendbaren E/A-Automatisierungsgerätes stark vereinfacht zeigen, während die Figur 1 ein beispielhaftes, von einer Verwendung im Rahmen des Schutzumfangs der Erfindung jedoch nicht umfasstes E/A-Automatisierungsgerät stark vereinfacht zeigt. So veranschaulichen die Figuren jeweils ein Prinzip eines E/A-Automatisierungsgerätes 100, welches wenigstens einen zweipoligen Spannungsversorgungsanschluss 140, 150 zum Anschließen an eine in den Figuren nicht dargestellte Spannungsversorgung und wenigstens einen zweipoligen Peripherieanschluss besitzt, welcher als zweipoliger Eingangsperipherieanschluss 560_0, 560_n (Fig. 3) zum Anschließen eines Sensors 610_0, 610_n oder als zweipoliger Ausgangsperipherieanschluss 160, 160_0, 160_n (Fig. 1, Fig. 2) zum Anschließen eines Aktors 210, 210_0, 210_n ausgebildet ist. Von einem ersten Pol 140 des Spannungsversorgungsanschlusses ausgehend ist ein erster Strompfad 140_1 im E/A-Automatisierungsgerät 100 beherbergt, der für einen Stromfluss in Richtung zu einem jeweils ersten Pol des wenigstens einen zweipoligen Peripherieanschlusses dient und von dem zweiten Pol 150 des Spannungsversorgungsanschlusses ausgehend ist ein zweiter Strompfad 150_1 im E/A Gerät 100 beherbergt, der für einen Stromfluss in Richtung von dem jeweils zweiten Pol des wenigstens einen zweipoligen Peripherieanschlusses dient. Die jeweiligen, in den Figuren dargestellten E/A-Automatisierungsgeräte besitzen ferner eine Stromflussüberwachungseinheit 110, 120, 130, um eine fehlerhafte Installation zwischen der Spannungsversorgung und wenigstens einem an dem wenigstens einen zweipoligen Peripherieanschluss angeschlossenen Aktor oder Sensor zu diagnostizieren. Hierzu ist die Stromflussüberwachungseinheit ausgebildet und angeordnet, um nach Installation des Spannungsversorgungsanschlusses 140, 150 an die Spannungsversorgung und eines Aktors oder Sensors an jeden des wenigstens einen Peripherieanschlusses in Bezug auf den jeweils ersten Pol des wenigstens einen zweipoligen Peripherieanschlusses wenigstens einen ersten, über den ersten Strompfad geleiteter Stromfluss sowie in Bezug auf den jeweils zweiten Pol des wenigstens einen zweipoligen Peripherieanschlusses wenigstens einen zweiten, über den zweiten Strompfad geleiteter Stromfluss zu messen. Die Stromflussüberwachungseinheit ist ferner ausgebildet und angeordnet, um daraufhin die gemessenen Stromflüsse miteinander zu vergleichen, um hierauf basierend wenigstens einen Installationsüberwachungswert zu bilden, sowie um dann jeden gebildeten Installationsüberwachungswert gegenüber wenigstes einem vorgebbaren oder vorgegebenen Grenzwert zu vergleichen, und um bei Erreichen oder Über-/Unterschreiten eines Grenzwertes durch wenigstens einen der Installationsüberwachungswerte auf einen Installationsfehler zu erkennen und zur Anzeige des Vorliegens eines Installationsfehlers ein Installationsfehlersignal zu erzeugen und auszugeben.

Bevorzugt umfasst jede Stromflussüberwachungseinheit der in den Figuren skizziert dargestellten E/A-Automatisierungsgeräte 100 für jeden zu messenden Stromfluss eine Strommesseinrichtung 110, 120 und eine Logikeinheit 130, an welche die Messergebnisse der gemessenen Stromflüsse zum weiteren Verarbeiten übergeben werden. Für die Logikeinheit 130 ist hierbei zweckmäßig von dem ersten und dem zweiten Strompfad ein Stromfluss parallel zu jedem anzuschließenden Aktor oder Sensor bereitgestellt. Stellt z.B. der Strompfad 140_1 die Plusleitung und der Strompfad 150_1 die Minusleitung dar, so muss bei korrekter Installation der Stromfluss in der Plusleitung, basierend auf den Figuren, ab dem Abzweig "A1", an welchem die Versorgung für die Logikeinheit 130 vom ersten Strompfad 140_1 abgezweigt wird, und also für den dem Abzweig "A1" nachfolgenden Strompfadbereich 140_1n1 des ersten Strompfads 140_1 der Differenz aus dem im ersten Strompfad 140_1 bis zum Abzweig "A1" fließenden Stromfluss und dem am Abzweig "A1" abgezweigten Stromfluss entsprechen. Ferner muss in diesem Fall und basierend auf den Figuren bei korrekter Installation der Stromfluss in der Minusleitung vor dem Abzweig "A2", an welchem die Logikeinheit 130 wieder an den zweiten Strompfad 150_1 angeschaltet ist, und also für den dem Abzweig "A2" vorhergehenden Strompfadbereich 150-1v1 des zweiten Strompfades 150_1 dem Stromfluss im Strompfadbereich 140_1n1 entsprechen.

Insbesondere, um für die funktionale Sicherheit unkritische Stromschwankungen oder -abflüsse bei der Diagnose auf fehlerhafte Installation zu berücksichtigen und/oder, um auch zu hohe oder zu niedrige, und also für die funktionale Sicherheit kritische Stromflüsse zu erkennen, trotzdem keine oder eine für die funktionale Sicherheit ausreichend kleine Differenz zwischen den Stromflüssen im ersten und zweiten Strompfad 140_1, 140_2 vorliegt, besitzt die Logikeinheit 130 zweckmäßig eine in den Figuren nicht weiter dargestellte Speichereinrichtung, um wenigstens eines vorgebbaren oder vorgegebenen Grenzwert zu speichern, um jeden gebildeten Installationsüberwachungswert gegenüber einem solchen Grenzwert durch die Stromüberwachungseinheit zu vergleichen.

Die in den Figuren 2 und 3 skizzierten E/A-Automatisierungsgeräte 100 mit den integrierten Stromflussüberwachungseinrichtungen 110, 120 130 können bevorzugt im Rahmen der Erfindung verwendet werden, d.h. zur Verwendung eines E/A-Automatisierungsgerätes 100 mit wenigstens einem zweipoligen Spannungsversorgungsanschluss 140, 150 zum Anschließen an eine Spannungsversorgung und mit wenigstens zwei zweipoligen Peripherieanschlüssen, welche als zweipolige Eingangsperipherieanschlüsse 560_0, 560_n zum Anschließen einer entsprechenden Anzahl von sicheren Sensoren 610_0, 610_n oder als zweipolige Ausgangsperipherieanschlüsse 160, 160_0, 160_n zum Anschließen einer entsprechenden Anzahl von sicheren Aktoren 210, 210_0, 210_n ausgebildet ist, wobei von einem ersten Pol des Spannungsversorgungsanschlusses 140 ausgehend ein erster Strompfad 140_1 im E/A Automatisierungsgerät beherbergt ist, der für einen Stromfluss in Richtung zu einem jeweils ersten Pol der wenigstens zwei zweipoligen Peripherieanschlüsse dient und von dem zweiten Pol des Spannungsversorgungsanschlusses 150 ausgehend ein zweiter Strompfad 150_1 im E/A Gerät beherbergt ist, der für einen Stromfluss aus Richtung der wenigstens zwei zweipoligen Peripherieanschlüsse dient, wobei die an die wenigstens zwei zweipoligen Peripherieanschlüsse anzuschließenden sicheren Aktoren 210_0, 210_n oder sicheren Sensoren 610_0, 610_n parallel zueinander zwischen dem ersten 140_1 und dem zweiten Strompfad 150_1 installiert werden, und mit einer Stromflussüberwachungseinheit 110, 120, 130, und zwar zum Diagnostizieren einer fehlerhaften Installation zwischen der Spannungsversorgung und wenigstens einem an einem der wenigstens zwei zweipoligen Peripherieanschlüsse angeschlossenen Aktor oder Sensor und also zur Überwachung der funktionalen Sicherheit, wobei nach Installation des Spannungsversorgungsanschlusses an die Spannungsversorgung und eines Aktors oder Sensors über Zweileiteranschlüsse an jeden der wenigstens zwei Peripherieanschlüsse von der Stromflussüberwachungseinheit in Bezug auf den jeweils ersten Pol der wenigstens zwei zweipoligen Peripherieanschlüsse wenigstens ein erster, über den ersten Strompfad geleiteter Stromfluss sowie in Bezug auf den jeweils zweiten Pol des wenigstens einen zweipoligen Peripherieanschlusses wenigstens ein zweiter, über den zweiten Strompfad geleiteter Stromfluss gemessen wird, wobei entweder ein Stromfluss als erster Stromfluss gemessen wird, der insgesamt in Richtung der jeweils ersten Pole der wenigstens zwei zweipoligen Peripherieanschlüsse geführt wird, sowie ein Stromfluss als zweiter Stromfluss gemessen wird, der insgesamt aus Richtung der wenigstens zwei zweipoligen Peripherieanschlüsse abgeführt wird, und hieraus ein gemeinsamer Installationsüberwachungswert gebildet wird, oder für jeden ersten Pol der wenigstens zwei zweipoligen Peripherieanschlüsse jeweils ein eindeutig zuordenbarer Stromfluss als erster Stromfluss gemessen wird, sowie für jeden der wenigstens zwei zweipoligen Peripherieanschlüsse ein aus dieser Richtung kommender, eindeutig zuordenbarer Stromfluss als zweiter Stromfluss gemessen wird und hieraus für jeden Peripherieanschluss jeweils ein eindeutig zuordenbarer Installationsüberwachungswert gebildet wird, die gemessenen Stromflüsse zur Bildung wenigstens eines Installationsüberwachungswertes miteinander verglichen werden, jeder gebildete Installationsüberwachungswert gegenüber wenigstes einem vorgebbaren oder vorgegebenen Grenzwert verglichen wird, und bei Erreichen oder Über-/Unterschreiten eines Grenzwertes durch wenigstens einen der Installationsüberwachungswerte auf einen Installationsfehler erkannt und zur Anzeige des Vorliegens eines Installationsfehlers ein Installationsfehlersignal erzeugt und ausgegeben wird.

Ferner wird hierbei, wie vorstehend aufgezeigt, bevorzugt die Differenz von gemessenen Stromflüssen zur Bildung wenigstens eines Installationsüberwachungswertes gebildet.

Darüber hinaus wird in bevorzugter Weise, wie vorstehend aufgezeigt, jeder gemessene Stromfluss von einer Strommesseinrichtung 110, 120 der Stromflussüberwachungseinheit gemessen und von der Strommesseinrichtung 110, 120 an eine Logikeinheit 130 der Stromflussüberwachungseinheit zum weiteren Verarbeiten übergeben. Auch wird in bevorzugter Weise hierfür der verwendeten Logikeinheit 130 von dem ersten und dem zweiten Strompfad ein Stromfluss parallel zu jedem anzuschließenden Aktor oder Sensor bereitgestellt, wobei ferner zweckmäßig von der Logikeinheit 130 eine in den Figuren nicht gezeigte Speichereinrichtung zur Speicherung des wenigstens einen vorgebbaren oder vorgegebenen Grenzwert bereitgestellt wird.

Im Einzelnen skizziert Fig. 1 ein beispielhaftes, im Rahmen des Schutzumfangs der Erfindung jedoch nicht umfasstes E/A-Automatisierungsgerät 100, welches einen Spannungsversorgungsanschluss mit zwei an eine Versorgungsspannung anzuschließenden Polen 140 und 150 umfasst. Diese können z.B. auch zusammen mit anderen Spannungsversorgungsanschluss-Polen weiterer E/A-Automatisierungsgeräte über Sammelschienen an eine gemeinsame Spannungsversorgung angeschlossen werden.

Der vom Anschlusspol 140 ausgehende Strompfad 140_1, welcher bspw. die Plusleitung darstellt, ist an einen Ausgangstreiber 200 angeschaltet, und der Ausgangstreiber 200 ist ausgangsseitig wiederum an einen ersten Anschlussport eines Peripherieanschlusses 160 angeschaltet. Der vom Anschlusspol 150 führende Leitungspfad 150_1 ist an einen zweiten Anschlussport des Peripherieanschlusses 160 angeschaltet. An beide Anschlussports des Peripherieanschlusses 160 ist ein Aktor 210, und also eine externe Last angeschlossen, wobei der Aktor 210, in Reihe zum Ausgangstreiber 200 angeschlossen ist. Der Aktor 210 ist folglich über einen Zweileiteranschluss angeschaltet und kann dementsprechend auch bevorzugt ein den Anforderungen genügender sicherer Aktor sein.

Eine Stromflussüberwachungseinheit ist ferner basierend auf Fig. 1 zweckmäßig durch zwei Strommesseinrichtungen 110 und 120 sowie eine Logikeinheit 130 gebildet.

So ist z.B. im Leitungspfad 140_1 zwischen dem Anschlusspol 140 und dem Ausgangstreiber 200 eine erste Strommessschaltung 110 elektrisch in Reihe geschaltet, und ebenso ist im Strompfad 150_1 zwischen dem Anschlusspol 150 und dem zweiten Anschlussport des Peripherieanschlusses 160 eine zweite Strommesseinrichtung 120 elektrisch in Reihe geschaltet. Ferner ist zwischen den Strompfaden 140_1 und 150_1 eine Logikeinheit 130 angeschaltet, wobei diese über einen ersten Strompfadabzweig "A1" an den Leitungspfad 140_1 zwischen dem Anschlusspol 140 und der ersten Strommesseinrichtung 110 angeschlossen ist und über einen zweiten Strompfadabzweig "A2" an den Leitungspfad 150_1 zwischen dem Anschlusspol 150 und der zweiten Strommesseinrichtung 120 angeschlossen ist.

Ab dem Strompfadabzweig "A1", an welchem die Logikeinheit 130 angeschaltet ist, ist dann der nachfolgende Strompfadbereich 140_1n1 des ersten Strompfades 140_1 zusammen mit dem Ausgangstreiber 200, dem zu diesem in Reihe und über den als Ausgangsperipherieanschluss 160 fungierenden Peripherieanschluss angeschalteten Aktor 210 und dem ausgangsseitig vom Aktor 210 als Minusleitung fungierenden Strompfadbereich 150_1v1 bis zum Strompfadabzweig "A2", an welchem wiederum die Logikeinheit 130 mit dem Strompfad 150_1 gekoppelt ist, parallel zu der Logikeinheit 130 geschaltet.

In Folge dessen, detektiert die Strommesseinrichtung 110 in Bezug auf den ersten Pol des zweipoligen Ausgangsperipherieanschlusses 160 bei korrekter Installation im E/A-Automatisierungsgerät einen ersten, über den ersten Strompfad geleiteten Stromfluss, welcher der Differenz des am Anschlusspol 140 anliegenden Stromflusses und des am Strompfadabzweig "A1" für die Logikeinheit 130 abgezweigten Stromanteils entspricht.

Entsprechend muss jedoch der Stromfluss in Bezug auf den ersten Pol des zweipoligen Eingangsperipherieanschlusses 160, welcher von der Strommesseinrichtung 110 detektiert wird, bei korrekter Installation an der Stelle der Strommesseinrichtung 120 anliegen.

Beide Strommesseinrichtungen 110 und 120 sind über Signalpfade 110_1 bzw. 120_1 mit der Logikeinheit 130 verbunden, um den gemessenen Stromflüssen entsprechende Messwerte an die Logikeinheit 130 zu übergeben, welche daraufhin die beiden durch die Strommesseinrichtungen 110 und 120 erfassten Stromflüsse miteinander zur Bildung wenigstens eines Installationsüberwachungswertes vergleicht und das Vergleichsergebnis auswertet.

Arbeitet die Logikeinheit 130 zweckmäßig digital, so müssen entsprechend die analogen Stromflüsse und die diese repräsentierenden Signale oder Messwerte, welche durch die Strommesseinrichtungen 110 und 120 ermittelt werden, digital umgesetzt werden.

Wie vorstehend beschrieben, wird bevorzugt die Differenz der gemessenen Stromflüsse ausgewertet. Liegt eine Differenz von "Null" vor, so ist zunächst von einer korrekten Verdrahtung und also von einer korrekten Installation auszugehen. Liegt eine Differenz größer oder kleiner "Null" vor, ist zunächst von einer unkorrekten Verdrahtung und also von einer unkorrekten Installation auszugehen.

Um jedoch ggf. auftretende Schwankungen im Stromfluss und/oder geringe Stromabflüsse berücksichtigen zu können, welche unter Umständen zu unterschiedlichen gemessenen und miteinander zu vergleichenden Stromflüssen führen, ist bevorzugt in der Logikeinheit 130 ein Grenzwert vorgebbar oder vorgegeben, bis zu welchem eine Differenz von größer oder kleiner "Null" unkritisch für die funktionale Sicherheit ist. Erst, wenn die von der Logikeinheit 130 festgestellte Stromflussdifferenz diesen Grenzwert erreicht, überschreitet oder unterschreitet ergibt folglich die Auswertung, dass die Installation in Bezug auf den Aktor nicht den Vorgaben der funktionalen Sicherheit entspricht.

Darüber hinaus kann in einer in den Fig. 1 nicht gezeigten Speichereinrichtung zweckmäßig auch ein vorgebbarer oder vorgegebener Grenzwert abgespeichert sein, um auch zu hohe oder zu niedrige, und also für die funktionale Sicherheit kritische Stromflüsse in ersten und/oder zweiten Strompfad 140_1 bzw. 150_1 zu erkennen, trotzdem keine oder eine für die funktionale Sicherheit ausreichend kleine Differenz zwischen den Stromflüssen im ersten und zweiten Strompfad 140_1, 140_2 vorliegt. Auch gegenüber einen solchen Grenzwert wird der durch Vergleich der gemessenen Stromflüsse gebildete Installationsüberwachungswert zweckmäßig verglichen, wobei dieser dann zusätzlich zur Differenz noch Werte beinhaltet, die die gemessenen Stromflüsse selbst repräsentieren.

Erreicht die entsprechende Differenz eines applikationsspezifisch entsprechenden Grenzwertes oder liegt diese Differenz außerhalb dieses Grenzwertes oder ist der gemessene Stromfluss im ersten und/oder im zweiten Strompfad zu hohe oder zu niedrig, liegen somit für die funktionale Sicherheit kritische Stromflüsse vor, und die Auswertung führt dazu, dass eine unkorrekte oder fehlerhafte Installation in Bezug auf den Anschluss der externen Last 210 vorliegt.

Ferner ist vorgesehen, dass die Stromflussüberwachungseinrichtung, d.h. gemäß den Figuren die Logikeinheit, derart ausgebildet ist, einen solchen festgestellten Installationsfehler zu melden. Dies erfolgt zweckmäßig, indem zur Anzeige des Vorliegens eines Installationsfehlers ein Installationsfehlersignal erzeugt und ausgegeben wird, sodass eine entsprechende Reaktion eingeleitet werden kann, bevor eine unkontrollierbare Situation entsteht.

Eine derartige Reaktion kann basierend auf Fig. 1 bspw. das "Fahren" des E/A-Automatisierungsgerätes 100 und/oder des Aktors 210 in einen sicheren Zustand sein, bspw. durch Abschalten des Stromflusses.

Mittels eines in Fig. 1 und auch den übrigen Figuren nicht dargestellten, von der Logikeinrichtung erzeugten Installationsfehlersignal wird zweckmäßig somit ein Abschalten zumindest des Aktors oder gegebenenfalls auch eines Sensors eingeleitet, der an den Polen des wenigstens einen zweipoligen Peripherieanschlusses angeschaltet ist, in Bezug auf welchen die gemessenen Stromflüsse zur Bildung des Installationsüberwachungswertes miteinander verglichen werden, bei welchem durch die Stromflussüberwachungseinheit auf einen Installationsfehler erkannt wird.

Ein diesbezügliches Installationsfehlersignal kann je nach weiterer applikationsspezifisch individueller Ausführung durch die Stromflussüberwachungseinrichtung spezieller z.B. entweder lokal auf dem E/A-Automatisierungsgerät 100 selbst, z.B. mittels einer entsprechenden optischen und/oder akustischen Diagnoseanzeige erfolgen (in den Fig. nicht dargestellt). Ergänzend oder alternativ kann die Stromflussüberwachungseinrichtung und insbesondere die Logikeinheit 130 jedoch auch einen separaten Meldeausgang beinhalten (in den Fig. nicht dargestellt), über welchen das Installationsfehlersignal an anderer Stelle innerhalb eines Prozesses zurückgemeldet wird. Ergänzend oder alternativ kann die Stromflussüberwachungseinrichtung und insbesondere die Logikeinheit 130 das Installationsfehlersignal auch über ein in den Figuren nicht dargestelltes Bussystem z.B. an eine überlagerte, ebenfalls nicht dargestellte Steuerung gemeldet werden und/oder an eine Einrichtung zum direkten Einwirken auf einen jeweiligen Peripherieanschluss geleitet werden. Die letztgenannte Möglichkeit ist z.B. bei den im Rahmen der Erfindung verwendbaren Ausführungen gemäß Fign. 2 und 3 vorgesehen, deren Abwandlungen zu der Ausführungsform nach Fig. 1 nachfolgend beschrieben werden.

Ansonsten entsprechen sich Elemente, die mit den selben Bezugzeichen belegt sind.

Fign. 2 und 3 zeigen in Abwandlung zu Fig. 1 Ausführungsformen, bei welcher das E/A-Automatisierungsgerät 100 wenigstens zwei zweipolige Peripherieanschlüsse 160_0 bis 160_n (Fig. 2) oder 560_0 bis 560_n, mit n = 1 bis N, besitzt und folglich eine entsprechende Anzahl von Aktoren 210_0 bis 210_n oder auch Sensoren 610_0 bis 610_n an diese anzuschließen sind.

Basierend auf den Fign. 2 und 3 sind bei wenigstens zwei zweipoligen Peripherieanschlüssen, diese sowie die im Fall von als Ausgangsperipherieanschlüsse ausgebildeten Peripherieanschlüsse 160_0 bis 160_n daran anzuschließenden sicheren Aktoren 210_0 bis 210_n bzw. die im Fall von als Eingangsperipherieanschlüsse ausgebildeten Peripherieanschlüsse 560_0 bis 560_n daran anzuschließenden sicheren Sensoren 610_0 bis 610_n Sensoren parallel zu einander zwischen dem ersten und dem zweiten Strompfad 140_1 bzw. 150_1 installiert.

Eine im Rahmen der Erfindung verwendete Stromflussüberwachungseinheit ist basierend auf den Fign. 2 und 3 wiederum in einem ersten Fall zweckmäßig durch zwei Strommesseinrichtungen 110 und 120 sowie eine Logikeinheit 130 gebildet.

Bei der Ausführungsform nach Fig. 2 verzweigt sich der vom Anschlusspol 140 ausgehende Strompfad 140_1, welcher bspw. die Plusleitung darstellt, an einem mit "B1" gekennzeichneten Strompfadabzweig zu einem Ausgangstreiber 200_0, der ausgangsseitig wiederum an einen ersten Anschlussport des Peripherieanschlusses 160_0 angeschaltet ist sowie zu hierzu parallel angeordneten Ausgangstreiber 200_n, der ausgangsseitig wiederum an einen ersten Anschlussport des Peripherieanschlusses 160_n angeschaltet ist. Der vom Anschlusspol 150 führende Leitungspfad 150_1 verzweigt sich an einem mit "B2" gekennzeichneten Strompfadabzweig zu einem zweiten Anschlussport des Peripherieanschlusses 160_0 sowie zu einem zweiten Anschlussport des Peripherieanschlusses 160_n angeschaltet. An beide Anschlussports der Peripherieanschlüsse 160_0 und 160_n ist jeweils ein Aktor 210_0 bzw. 201_n, und also eine externe Last angeschlossen, wobei der Aktor 210_0 in Reihe zum Ausgangstreiber 200_0 und Aktor 210_n in Reihe zum Ausgangstreiber 200_n angeschlossen ist. Auch die Aktoren 210_0 und 210_n sind folglich über Zweileiteranschlüsse angeschaltet und können dementsprechend auch bevorzugt den Anforderungen genügende sichere Aktoren sein. Sind weitere Peripherieanschlüsse für weitere anzuschließende Aktoren vorhanden, sind bevorzugt entsprechend weitere Strompfadabzweige vorgesehen, so dass die parallele Anordnung fortgesetzt ist.

Ferner ist gemäß Fig. 2 im Leitungspfad 140_1 zwischen dem Anschlusspol 140 und dem mit "B1" gekennzeichneten Strompfadabzweig eine erste Strommessschaltung 110 elektrisch in Reihe geschaltet, und ebenso ist im Strompfad 150_1 zwischen dem Anschlusspol 150 und dem mit "B2" gekennzeichneten Strompfadabzweig eine zweite Strommesseinrichtung 120 elektrisch in Reihe geschaltet und zwischen den Strompfaden 140_1 und 150_1 ist die Logikeinheit 130 angeschaltet, wobei diese wiederum über einen ersten Strompfadabzweig "A1" an den Leitungspfad 140_1 zwischen dem Anschlusspol 140 und der ersten Strommesseinrichtung 110 angeschlossen ist und über einen zweiten Strompfadabzweig "A2" an den Leitungspfad 150_1 zwischen dem Anschlusspol 150 und der zweiten Strommesseinrichtung 120 angeschlossen ist.

Die Logikeinheit 130 ist also wiederum parallel zu den Ausgangstreibern 200_0 und 200_n und den jeweils zu diesen in Reihe geschalteten und über die als Ausgangsperipherieanschlüsse 160_0 oder 160_n fungierenden Peripherieanschlüsse angeschalteten Aktor 210_0 bzw. 210_n geschaltet.

In Folge dessen, detektiert gemäß Fig. 2 die Strommesseinrichtung 110 einen ersten Stromfluss, der insgesamt in Richtung der jeweils ersten Polen der zweipoligen Ausgangsperipherieanschlüssen 160_0 und 160_n geführt wird sowie einen zweiten Stromfluss, der insgesamt aus Richtung der zweipoligen Ausgangsperipherieanschlüssen 160_0 und 160_n abgeführt wird, so dass hieraus ein gemeinsamer Installationsüberwachungswert durch die Logikeinheit 130 gebildet wird.

Bei Verwendung des E/A-Automatisierungsgerätes 100 nach Fig. 2, welches somit als Ausgangsgerät, d.h. ein Ausgangsgerät der funktionalen Sicherheit, mit wenigstens zwei daran anzuschließenden Aktoren bildet, wird folglich eine Summenstrommessung aller Ausgänge des E/A-Automatisierungsgeräts durchgeführt.

Bei der Ausführungsform nach Fig. 3 verzweigt sich der vom Anschlusspol 140 ausgehende Strompfad 140_1, welcher bspw. die Plusleitung darstellt, an einem mit "B1" gekennzeichneten Strompfadabzweig zu einer ersten Eingangsschaltung 600_0 und zu einem ersten Anschlussport des Peripherieanschlusses 560_0 sowie zu einer zweiten Eingangsschaltung 600_n und zu einem ersten Anschlussport des Peripherieanschlusses 560_n. An diese ersten Anschlussports ist jeweils Sensor 610_0 oder 610_n in Reihe geschaltet. Der Sensor 610_0 ist ausgangsseitig über den zweiten Anschlussports des Peripherieanschlusses 560_0 wieder an einen Eingang der Eingangsschaltung 600_0 geschaltet und der Sensor 610_n ist ausgangsseitig über den zweiten Anschlussports des Peripherieanschlusses 560_n wieder an einen Eingang der Eingangsschaltung 600_n geschaltet.

Die Eingangsschaltungen 600_0 und 600_n sind Stromausgangsseitig wieder an einem mit "B2" gekennzeichneten Strompfadabzweig mit dem Strompfad 150_1 vereinigt.

Auch hier sind folglich die Sensoren 610_0 und 610_n zueinander parallel geschaltet wie auch die jeweiligen Eingangsschaltungen 600_0 und 600_n.

Auch sind die Sensoren 610_0 und 610_n folglich über Zweileiteranschlüsse angeschaltet und können dementsprechend auch bevorzugt den Anforderungen genügende sichere Sensoren sein. Sind weitere Peripherieanschlüsse für weitere anzuschließende Sensoren vorhanden, sind bevorzugt entsprechend weitere parallele Anordnungen vorgesehen.

Entsprechend zu Fig. 2 ist auch gemäß Fig. 3 im Leitungspfad 140_1 zwischen dem Anschlusspol 140 und dem mit "B1" gekennzeichneten Strompfadabzweig eine erste Strommessschaltung 110 elektrisch in Reihe geschaltet, und ebenso ist im Strompfad 150_1 zwischen dem Anschlusspol 150 und dem mit "B2" gekennzeichneten Strompfadabzweig eine zweite Strommesseinrichtung 120 elektrisch in Reihe geschaltet und zwischen den Strompfaden 140_1 und 150_1 ist die Logikeinheit 130 angeschaltet, wobei diese wiederum über einen ersten Strompfadabzweig "A1" an den Leitungspfad 140_1 zwischen dem Anschlusspol 140 und der ersten Strommesseinrichtung 110 angeschlossen ist und über einen zweiten Strompfadabzweig "A2" an den Leitungspfad 150_1 zwischen dem Anschlusspol 150 und der zweiten Strommesseinrichtung 120 angeschlossen ist.

Die Logikeinheit 130 ist also wiederum parallel zu den Eingangsschaltungen 600_0 und 600_n und den jeweils diesen zugeordneten und über die als Eingangsperipherieanschlüsse 560_0 oder 560_n fungierenden Peripherieanschlüsse angeschalteten Sensoren 610_0 bzw. 610_n geschaltet.

In Folge dessen, detektiert auch gemäß Fig. 3 die Strommesseinrichtung 110 einen ersten Stromfluss, der insgesamt in Richtung der jeweils ersten Pole der zweipoligen Eingangsperipherieanschlüssen 560_0 und 560_n geführt wird sowie einen zweiten Stromfluss, der insgesamt aus Richtung der zweipoligen Eingangsperipherieanschlüsse 560_0 und 560_n abgeführt wird, wobei der zweite Stromfluss auch den Stromfluss in Bezug auf den jeweils zweiten Pol der zweipoligen Eingangsperipherieanschlüsse 560_0 und 560_n berücksichtigt, so dass hieraus ein gemeinsamer Installationsüberwachungswert durch die Logikeinheit 130 gebildet wird.

Bei Verwendung des E/A-Automatisierungsgerätes 100 nach Fig. 3, welches somit als Eingangsgerät, d.h. ein Eingangsgerät der funktionalen Sicherheit, mit wenigstens zwei daran anzuschließenden Sensoren bildet, wird folglich eine Summenstrommessung aller Eingänge des E/A-Automatisierungsgeräts durchgeführt.

Wie aus den Fign. 2 und 3 ferner zu sehen, sind zwischen der Logikeinheit 130 und den Ausgangstreibern 200_0 und 200_n Signalpfade 201_0 oder 201_n bzw. zwischen der Logikeinheit 130 und den Eingangsschaltungen 600_0 und 600_n Signalpfade 601_0 oder 601_n geführt, über welche insbesondere die Aktoren betreffende Informationen an die Ausgangstreiber bzw. von den Sensoren erhaltene Informationen ausgetauscht werden können.

Die Stromflussüberwachungseinrichtung und insbesondere die Logikeinheit 130 kann bevorzugt auch ein erzeugtes Installationsfehlersignal über die Signalpfade 201_0 und 201_n an die Ausgangstreiber 200_0 oder 200_n bzw. die Signalpfade 601_0 und 601_n an die Eingangsschaltung 600_0 oder 600_n zum direkten Einwirken auf den jeweiligen Peripherieanschluss leiten. Sind an diese Aktoren angeschlossen, kann hierdurch folglich z.B. die Stromzufuhr abgeschaltet werden; sind an diese Sensoren angeschlossen, kann z.B. der vom Sensor an die jeweilige Eingangsschaltung rückgeführte Pfad wirkungslos geschaltet werden.

In weiterer Abwandlung zu den in den Fign. 2 und 3 dargestellten Ausführungsformen sind im Rahmen der Erfindung z.B. auch E/A-Automatisierungsgeräte verwendbar, bei welchen anstelle der ersten Strommesseinrichtung 110 und anstelle der zweiten Strommesseinrichtung 120 eine erste Strommesseinrichtung im Strompfadbereich 140_1n2, eine zweite Strommesseinrichtung im Strompfadbereich 140_1v2, eine dritte Strommesseinrichtung im Strompfadbereich 140_1n3, eine vierte Strommesseinrichtung im Strompfadbereich 140_1v3 angeordnet ist. Sind weitere Peripherieanschlüsse für weitere anzuschließende Aktoren und/oder Sensoren vorhanden, sind bevorzugt entsprechend weitere Anordnungen von Strommesseinrichtungen vorgesehen.

In diesem Fall werden zweckmäßig die von der ersten Strommesseinrichtung im Strompfadbereich 140_1n2 und von der zweiten Strommesseinrichtung im Strompfadbereich 140_1v2 gemessenen Stromflüsse miteinander und gegenüber Grenzwerten verglichen und entsprechend die von der dritten Strommesseinrichtung im Strompfadbereich 140_1n3 und von der vierten Strommesseinrichtung im Strompfadbereich 140_1v3 gemessenen Stromflüsse miteinander und gegenüber Grenzwerten verglichen.

Wird folglich für jeden ersten Pol der wenigstens zwei zweipoligen Peripherieanschlüsse jeweils ein eindeutig zuordenbarer erster Stromfluss gemessen, sowie für jeden der wenigstens zwei zweipoligen Peripherieanschlüsse ein aus dieser Richtung kommender, eindeutig zuordenbarer zweiter Stromfluss gemessen und hieraus für jeden Peripherieanschluss jeweils ein eindeutig zuordenbarer Installationsüberwachungswert gebildet, kann bei Verwendung eines solchen E/A-Automatisierungsgerätes, d.h. eines E/A-Automatisierungsgerätes der funktionalen Sicherheit, eine Einzelstrommessung für jeden Ausgangskreis oder Eingangskreis des Geräts durchgeführt werden.

Es sei darauf hingewiesen, dass in weiterer Abwandlung zu vorstehender Beschreibung auch Mischformen sowohl der Anordnung der Strommesseinrichtungen und/oder des Anschlusses nur von Aktoren oder nur von Sensoren in Bezug auf ein einzelnes E/A-Automatisierungsgerät im Rahmen der Erfindung möglich sind.

## Patentansprüche

1. Verwendung eines E/A-Automatisierungsgerätes (100) der funktionalen Sicherheit in einem sicherheitskritischen Prozess zum Diagnostizieren einer fehlerhaften Installation von an dem E/A-Automatisierungsgerät (100) angeschlossenen sicheren Aktoren (210_0, 210_n) und/oder sicheren Sensoren - (610_0, 610_n), wobei das E/A-Automatisierungsgerät (100) von den angebundenen Sensoren (610_0, 610_n) Eingangssignale zur weiteren Verarbeitung empfangen und/oder an die angebundenen Aktoren (210_0, 210_n) anwendungsspezifisch verarbeitete Ausgangssignale ausgeben kann,
- wobei das E/A-Automatisierungsgerät (100) zur Überwachung der funktionalen Sicherheit verwendet wird
und ausgestattet ist
- mit wenigstens einem zweipoligen Spannungsversorgungsanschluss (140, 150) zum Anschließen an eine Spannungsversorgung und mit wenigstens zwei zweipolige Peripherieanschlüsse, welche als zweipolige Eingangsperipherieanschlüsse (560_0, 560_n) zum Anschließen einer entsprechenden Anzahl von sicheren Sensoren (610_0, 610_n) über Zweileiteranschlüsse oder als zweipolige Ausgangsperipherieanschlüsse (160, 160_0, 160_n) zum Anschließen einer entsprechenden Anzahl von sicheren Aktoren (210_0, 210_n) über Zweileiteranschlüsse ausgebildet sind, wobei von einem ersten Pol des Spannungsversorgungsanschlusses (140) ausgehend ein erster Strompfad (140_1) im E/A-Automatisierungsgerät (100) beherbergt ist, der für einen Stromfluss in Richtung zu einem jeweils ersten Pol der wenigstens zwei zweipoligen Peripherieanschlüsse (160, 160_0, 160_n) dient und von dem zweiten Pol des Spannungsversorgungsanschlusses (150) ausgehend ein zweiter Strompfad (150_1) im E/A-Automatisierungsgerät (100) beherbergt ist, der für einen Stromfluss aus Richtung der wenigstens zwei zweipoligen Peripherieanschlüsse (160, 160_0, 160_n) dient, wobei die an die wenigstens zwei zweipoligen Peripherieanschlüsse anzuschließenden sicheren Aktoren (210_0, 210_n) oder sicheren Sensoren (610_0, 610_n) parallel zueinander zwischen dem ersten (140_1) und dem zweiten Strompfad (150_1) installiert werden,
- und einer Stromflussüberwachungseinheit (110, 120, 130) zum Diagnostizieren einer fehlerhaften Installation zwischen der Spannungsversorgung und wenigstens einem an einem der wenigstens zwei zweipoligen Peripherieanschlüsse (160) angeschlossenen Aktor (210_0, 210_n) oder Sensor (610_0, 610_n) und also zur Überwachung der funktionalen Sicherheit;
- wobei nach Installation des Spannungsversorgungsanschlusses (140, 150) an die Spannungsversorgung und eines sicheren Aktors (210_0, 210_n) oder sicheren Sensors (610_0, 610_n) über Zweileiteranschlüsse an jeden der wenigstens zwei Peripherieanschlüsse von der Stromflussüberwachungseinheit
- in Bezug auf den jeweils ersten Pol der wenigstens zwei zweipoligen Peripherieanschlüsse wenigstens ein erster, über den ersten Strompfad (140_1) geleiteter Stromfluss sowie in Bezug auf den jeweils zweiten Pol des wenigstens einen zweipoligen Peripherieanschlusses wenigstens ein zweiter, über den zweiten Strompfad (150_1) geleiteter Stromfluss gemessen wird, wobei
entweder ein Stromfluss als erster Stromfluss gemessen wird, der insgesamt in Richtung der jeweils ersten Pole der wenigstens zwei zweipoligen Peripherieanschlüsse geführt wird, sowie ein Stromfluss als zweiter Stromfluss gemessen wird, der insgesamt aus Richtung der wenigstens zwei zweipoligen Peripherieanschlüsse abgeführt wird, und hieraus ein gemeinsamer Installationsüberwachungswert gebildet wird,
oder für jeden ersten Pol der wenigstens zwei zweipoligen Peripherieanschlüsse jeweils ein eindeutig zuordenbarer Stromfluss als erster Stromfluss gemessen wird, sowie für jeden der wenigstens zwei zweipoligen Peripherieanschlüsse ein aus dieser Richtung kommender, eindeutig zuordenbarer Stromfluss als zweiter Stromfluss gemessen wird und hieraus für jeden Peripherieanschluss jeweils ein eindeutig zuordenbarer Installationsüberwachungswert gebildet wird,
- die gemessenen Stromflüsse zur Bildung wenigstens eines Installationsüberwachungswertes miteinander verglichen werden,
- jeder gebildete Installationsüberwachungswert gegenüber wenigstes einem vorgebbaren oder vorgegebenen Grenzwert verglichen wird, und
- bei Erreichen oder Über-/Unterschreiten eines Grenzwertes durch wenigstens einen der Installationsüberwachungswerte auf einen Installationsfehler erkannt und zur Anzeige des Vorliegens eines Installationsfehlers ein Installationsfehlersignal erzeugt und ausgegeben wird.

2. Verwendung nach Anspruch 1, wobei mittels des Installationsfehlersignals ein Abschalten zumindest des Aktors (210_0, 210_n) oder Sensors (610_0, 610_n) eingeleitet wird, der an den Polen eines der wenigstens zwei zweipoligen Peripherieanschlüsse angeschaltet ist, in Bezug auf welche die gemessenen Stromflüsse zur Bildung des Installationsüberwachungswertes miteinander verglichen werden, bei welchem durch die Stromflussüberwachungseinheit auf einen Installationsfehler erkannt wird.

3. Verwendung nach Anspruch 1 oder 2, wobei jeder gemessene Stromfluss von einer Strommesseinrichtung (110, 120) der Stromflussüberwachungseinheit gemessen wird und von der Strommesseinrichtung (110, 120) an eine Logikeinheit (130) der Stromflussüberwachungseinheit zum weiteren Verarbeiten übergeben wird.

4. Verwendung nach Anspruch 3, wobei für die Logikeinheit (130) von dem ersten und dem zweiten Strompfad ein Stromfluss parallel zu jedem anzuschließenden Aktor (210_0, 210_n) oder Sensor (610_0, 610_n) bereitgestellt wird.

5. Verwendung nach einem der vorherigen Ansprüche 3 oder 4, wobei von der Logikeinheit (130) eine Speichereinrichtung zur Speicherung des wenigstens einen vorgebbaren oder vorgegebenen Grenzwerts bereitgestellt wird.

6. Verwendung nach einem der vorstehenden Ansprüche 1 bis 5, wobei das Installationsfehlersignal optisch und/oder akustisch am E/A-Automatisierungsgerät angezeigt wird, über einen separaten Meldeausgang extern vom E/A-Automatisierungsgerät an anderer Stelle zurückgemeldet wird, über ein Bussystem an eine überlagerte Steuerung gemeldet wird und/oder an eine Einrichtung zum direkten Einwirken auf einen jeweiligen Peripherieanschluss geleitet wird.

7. Verwendung nach einem der vorherigen Ansprüche 1 bis 6, wobei die Differenz von gemessenen Stromflüssen zur Bildung wenigstens eines Installationsüberwachungswertes gebildet wird.

## Claims

1. Use of a functional safety I/O automation device (100) in a safety-critical process for diagnosing a faulty installation of safe actuators (210_0, 210_n) and/or safe sensors (610_0, 610_n) connected to the I/O automation device (100), wherein the I/O automation device (100) can receive input signals from the connected sensors (610_0, 610_n) for further processing and/or can output signals processed in an application-specific manner to the connected actuators (210_0, 210_n),
- wherein the I/O automation device (100) is used to monitor functional safety and is equipped,
- with at least one two-pole power supply connection (140, 150) for connection to a power supply and at least two two-pole peripheral connections which are adapted as two-pole input peripheral connections (560_0, 560_n) for connecting a corresponding number of safe sensors (610_0, 610_n) via two-wire connections or as two-pole output periphery connections (160, 160_0, 160_n) for connecting a a corresponding number of safe actuators (210_0, 210_n) via two-wire connections, wherein starting from a first pole of the voltage supply connection(140) a first current path (140_1) in the I/O- automation device (100) is accommodated, which is intended for current flow in the direction of a first pole of each of the at least two two-pole peripheral connections (160, 160_0, 160_n),
and starting from the second pole of the power supply connection (150), a second current path (150_1) is accommodated in the I/O automation device (100) automation device (100), which is intended for a current flow from the direction of the at least two two-pole peripheral connections (160, 160_0, 160_n), wherein the safe actuators (210_0, 210_n) or safe sensors (610_, 610_n) to be connected to the at least two-pole peripheral connections (160, 160_0, 160_n) are installed in parallel to one another between the first (140_1) and the second current path (150_1),
- and with a current flow monitoring unit (110, 120, 130) for diagnosing a faulty installation between the power supply and at least one actuator (210_0/ 210 n) or sensor (610_0, 610_n) connected to one of the at least two two-pole peripheral connections (160) and thus for monitoring functional safety;
- whereby after installation of the power supply connection (140, 150) to the power supply and of a safe actuator (210_0, 210_n) or safe sensor (610_0, 610_n) via two-wire connections to each of the at least two peripheral connections from the current flow monitoring unit
- with respect to the first pole of each of the at least two two-pole peripheral connections, at least one first current flow routed via the first current path (140_1), is connected to the current path (140_1) is measured and with respect to the respective second pole of the at least one two-pole at least a second current flow routed via the second current path (150_1) is measured, wherein
either a current flow is measured as the first current flow, which is routed in total in the direction of the respective first poles of the at least two two-pole connections and a current flow is measured as the second current flow, which is routed in total from the direction of the at least two two-pole peripheral connections and based thereon a common installation monitoring value is formed
or for each first pole of the at least two-pole peripheral connections in each case a uniquely assignable current flow is measured as the first current flow and for each of the at least two two-pole peripheral connections a current flow coming from this direction and being unambiguously assignable is measured as the second current flow and based thereon for each peripheral connection an unambiguously assignable installation monitoring value is formed in each case,
- the measured current flows are compared with one another to form at least one installation monitoring value,
- each installation monitoring value formed is compared with at least one predefinable or predefined limit value, and
- when a limit value is reached or exceeded/fallen short of by at least one of the installation monitoring values, an installation error is detected and an installation error signal is generated and output to indicate the presence of an installation error.

2. Use according to claim 1 wherein by means of the installation error signal a shutdown is initiated of at least the actuator (210_0, 210_n) or sensor (610_0, 610_n) connected to the poles of one of the at least two two-pole peripheral connections with respect to which the measured current flows are compared for the formation of the installation monitoring value based on which an installation fault is installation error is detected by the current measuring device.

3. Use according to claim 1 or 2, wherein each measured current flow is measured by a current measuring device (110, 120) of the current flow monitoring unit and is transmitted from the current measuring device (110, 120) to a logic unit (130) of the current flow monitoring unit for further processing.

4. Use according to claim 3, wherein for the logic unit (130) a current flow is provided parallel to each actuator (210_0, 210_n) or sensor (610_0), 610_n) to be connected from the first and second current paths .

5. Use according to one of the preceding claims 3 or 4, wherein a memory device for storing the at least one predefinable or predefined limit value is provided by the logic unit (130).

6. Use according to any of the preceding claims 1 to 5, wherein the installation error signal is indicated visually and/or acoustically at the I/O automation device, is reported back externally from the I/O automation device to another location via a separate signaling output, is signaled via a bus system to a higher-level controller and/or is routed to a device for direct action on a respective peripheral connection.

7. Use according to any of the preceding claims 1 to 6, wherein the difference of measured current flows is used to form at least one installation monitoring value.

## Revendications

1. Utilisation d'un appareil d'automatisation E/S (100) de la sécurité fonctionnelle dans un processus essentiel à la sécurité pour le diagnostic d'une installation défectueuse d'actionneurs sécurisés (210_0, 210_n) et/ou de capteurs sécurisés (610_0, 610_n) raccordés à l'appareil d'automatisation E/S (100), dans laquelle l'appareil d'automatisation E/S (100) peut recevoir des signaux d'entrée depuis les capteurs (610_0, 610_n) raccordés en vue d'un traitement ultérieur et/ou transmettre aux actionneurs (210_0, 210_n) raccordés des signaux de sortie traités de façon spécifique à l'application,
- dans laquelle l'appareil d'automatisation E/S (100) est utilisé pour la surveillance de la sécurité fonctionnelle
et est équipé
- avec au moins un raccord d'alimentation en tension (140, 150) bipolaire pour un raccordement à une alimentation en tension et avec au moins deux connecteurs périphériques bipolaires, lesquels sont conçus en tant que connecteurs périphériques d'entrée (560_0, 560_n) bipolaires pour le raccordement d'un nombre correspondant de capteurs sécurisés (610_0, 610_n) via des raccords bifilaires ou en tant que connecteurs périphériques de sortie (160, 160_0, 160_n) bipolaires pour le raccordement d'un nombre correspondant d'actionneurs sécurisés (210_0, 210_n) via des raccords bifilaires, où en partant d'un premier pôle du raccord d'alimentation en tension (140) un premier trajet de courant (140_1) est hébergé dans l'appareil d'automatisation E/S (100), lequel trajet de courant sert pour un flux de courant en direction d'un premier pôle respectif des au moins deux connecteurs périphériques (160, 160_0, 160_n) bipolaires, et en partant du second pôle du raccord d'alimentation en tension (150) un second trajet de courant (150_1) est hébergé dans l'appareil d'automatisation E/S (100), lequel trajet de courant sert pour un flux de courant depuis la direction des au moins deux connecteurs périphériques (160, 160_0, 160_n) bipolaires, où les actionneurs sécurisés (210_0, 210_n) ou les capteurs sécurisés (610_0, 610_n) à raccorder aux au moins deux connecteurs périphériques bipolaires sont installés parallèlement les uns aux autres entre le premier (140_1) et le second trajet de courant (150_1),
- et avec une unité de surveillance de flux de courant (110, 120, 130) pour le diagnostic d'une installation défectueuse entre l'alimentation en tension et au moins un actionneur (210_0, 210_n) ou capteur (610_0, 610_n) raccordés à un des au moins deux connecteurs périphériques (160) bipolaires et donc pour la surveillance de la sécurité fonctionnelle ;
- dans laquelle après l'installation du raccord d'alimentation en tension (140, 150) au niveau de l'alimentation en tension et d'un actionneur sécurisé (210_0, 210_n) ou d'un capteur sécurisé (610_0, 610_n) via des raccords bifilaires au niveau de chacun des au moins deux connecteurs périphériques de l'unité de surveillance de flux de courant
- par rapport au premier pôle respectif des au moins deux connecteurs périphériques bipolaires est mesuré au moins un premier flux de courant mené via le premier trajet de courant (140_1) ainsi que par rapport au second pôle respectif de l'au moins un connecteur périphérique bipolaire est mesuré au moins un second flux de courant mené via le second trajet de courant (150_1), où
soit un flux de courant est mesuré en tant que premier flux de courant qui est mené dans l'ensemble en direction du premier pôle respectif des au moins deux connecteurs périphériques bipolaires, ainsi qu'un flux de courant est mesuré en tant que second flux de courant qui est évacué dans l'ensemble depuis la direction des au moins deux connecteurs périphériques bipolaires, et partant de là est formée une valeur de surveillance d'installation commune,
soit pour chaque premier pôle des au moins deux connecteurs périphériques bipolaires est respectivement mesuré un flux de courant pouvant être clairement attribué en tant que premier flux de courant, ainsi que pour chacun des au moins deux connecteurs périphériques bipolaires est respectivement mesuré un flux de courant pouvant être clairement attribué et provenant de cette direction en tant que second flux de courant, et partant de là est respectivement formée pour chaque connecteur périphérique une valeur de surveillance d'installation qui peut être clairement attribuée,
- les flux de courant mesurés pour la formation d'au moins une valeur de surveillance d'installation sont comparés les uns aux autres,
- chaque valeur de surveillance d'installation formée est comparée à au moins une valeur limite qui est ou peut être prédéfinie, et
- lorsqu'au moins une des valeurs de surveillance d'installation atteint ou dépasse par le haut/bas une valeur limite, un défaut d'installation est détecté et un signal de défaut d'installation est produit et émis pour l'affichage de la présence d'un défaut d'installation.

2. Utilisation selon la revendication 1, dans laquelle, au moyen du signal de défaut d'installation, est déclenchée une coupure au moins de l'actionneur (210_0, 210_n) ou du capteur (610_0, 610_n), qui est activée au niveau des pôles de l'un des au moins deux connecteurs périphériques bipolaires, par rapport auxquels les flux de courant mesurés pour la formation de la valeur de surveillance d'installation sont comparés les uns aux autres, un défaut d'installation étant détecté par l'unité de surveillance de flux de courant.

3. Utilisation selon la revendication 1 ou 2, dans laquelle chaque flux de courant mesuré est mesuré par un équipement de mesure de courant (110, 120) de l'unité de surveillance de flux de courant et transmis par l'équipement de mesure de courant (110, 120) à une unité logique (130) de l'unité de surveillance de flux de courant pour un traitement ultérieur.

4. Utilisation selon la revendication 3, dans laquelle un flux de courant est fourni pour l'unité logique (130) par le premier et le second trajet de courant, parallèlement à chaque actionneur (210_0, 210_n) ou capteur (610_0, 610_n) à raccorder.

5. Utilisation selon l'une des revendications précédentes 3 ou 4, dans laquelle un équipement de stockage est fourni par l'unité logique (130) pour le stockage de l'au moins une valeur limite qui est ou peut être prédéfinie.

6. Utilisation selon l'une des revendications précédentes 1 à 5, dans laquelle le signal de défaut d'installation est affiché de façon optique et/ou acoustique sur l'appareil d'automatisation E/S, est notifié via une sortie de notification séparée à un autre emplacement extérieur à l'appareil d'automatisation E/S, est annoncé via un système de bus à une commande superposée et/ou est mené vers un équipement pour une action directe sur un connecteur périphérique respectif.

7. Utilisation selon l'une des revendications précédentes 1 à 6, dans laquelle la différence est formée par des flux de courant mesurés pour la formation d'au moins une valeur de surveillance d'installation.
